# EUROPÄISCHE PATENTSCHRIFT

(11) **EP 4 449 136 B1**
(45) Veröffentlichungstag und Bekanntmachung des Hinweises auf die Patenterteilung: **20.05.2026**
(21) Anmeldenummer: 22823080.1
(22) Anmeldetag: 01.12.2022
(51) Int. Cl.: G01R 31/26

(54) **KAPAZITIVER FUNKTIONSTEST VON VARISTOREN EINER FAHRZEUGBORDNETZ-HOCHVOLTSCHUTZVORRICHTUNG**
CAPACITIVE FUNCTIONALITY TEST FOR VARISTORS OF A HIGH-VOLTAGE PROTECTIVE DEVICE FOR AN ON-BOARD VEHICLE ELECTRICAL SYSTEM
TEST DE FONCTIONNALITÉ CAPACITIVE POUR VARISTANCES D'UN DISPOSITIF DE PROTECTION HAUTE TENSION POUR UN SYSTÈME ÉLECTRIQUE DE VÉHICULE EMBARQUÉ

(30) Priorität: 14.12.2021 DE 102021214316
(43) Veröffentlichungstag der Anmeldung: 23.10.2024
(73) Patentinhaber: Schaeffler Technologies AG & Co. KG, 91074 Herzogenaurach (DE)
(72) Erfinder: PFEILSCHIFTER, Franz, 80687 München (DE); GÖTZENBERGER, Martin, 80687 München (DE)
(74) Vertreter: Schaeffler Technologies
(86) Internationale Anmeldenummer: PCT/EP2022/084048
(87) Internationale Veröffentlichungsnummer: WO 2023/110433

(56) Entgegenhaltungen:
- WO-A2-2010/079132
- DE-A1- 102021 100 497
- DE-B3- 102020 207 878
- JP-B2- 6 070 470
- US-A1- 2021 124 078
- ZHOU D ET AL: "Degradation phenomena due to dc bias in low-voltage ZnO varistors", MATERIALS SCIENCE AND ENGINEERING: B, ELSEVIER, AMSTERDAM, NL, vol. 99, no. 1-3, 25 May 2003 (2003-05-25), pages 412 - 415, XP004433396, ISSN: 0921-5107, DOI: 10.1016/S0921-5107(02)00453-1

## Beschreibung

Es ist bekannt, Fahrzeuge mit elektrischen Antrieben auszustatten, die von Batterien gespeist werden. Hierbei sind neben Gleichspannungswandlern auch Inverter vorgesehen sowie Ladeschaltungen, die innerhalb des Fahrzeugbordnetzes mit dem Antrieb und der Batterie verbunden sind. Zum einen ist es zur Erreichung von hohen Leistungen erforderlich, dass diese Komponenten Hochvoltkomponenten sind und somit mit einer Nennspannung von mehr als 60 V, bspw. von 400 oder 800V arbeiten. Dies erfordert erhöhte Sicherheitsmaßnahmen, die bspw. durch eine Hochvoltisolierung gegeben sind, und insbesondere durch das Vorsehen eines Hochvoltbordnetzes, das galvanisch getrennt ist von Niedervoltabschnitten des Bordnetzes. Zum anderen ist es erforderlich, dass diese Hochvoltkomponenten überwacht oder angesteuert werden, wozu Niedervoltsignale verwendet werden. Diese Niedervoltsignale werden über Leitungen ausgetauscht, die sich aus dem Hochvolt-Bordnetzzweig heraus in den Niedervoltabschnitt hinein erstrecken.

JP 6 070470 B2 offenbart eine Zündvorrichtung. Die Zündvorrichtung umfasst eine Zündspule mit einer Primärspule und einer Sekundärspule, die magnetisch miteinander gekoppelt sind; eine Zündkerze mit einer Mittelelektrode und einer Masseelektrode; eine ECU 20 zum Anlegen einer Sekundärspannung an einen Spalt zum Erzeugen einer Funkenentladung in einem Spalt, der ein Zwischenraum zwischen der Mittelelektrode 10a und der Masseelektrode 10b ist; eine Diode 18 zum Begrenzen der Sekundärspannung V2, so dass sie einen vorbestimmten Wert nicht überschreitet; und ein Schaltelement 19, das parallel mit der Zündkerze 10 verbunden ist und die Sekundärspule 12b und die Diode 18 elektrisch trennt. Die ECU 20 bestimmt, ob eine Anomalie an der Diode 18 auftritt, wenn die Sekundärspannung V2 an den Spalt angelegt wird, und schaltet das Schaltelement 19 in einen Nicht-Verbindungszustand, wenn festgestellt wird, dass eine Anomalie an der Diode 18 auftritt.

WO 2010/079132 A2 offenbart ein Überspannungsschutzelement mit einem Gehäuse und mit mindestens einer in dem Gehäuse angeordneten Suppressor-Diode als überspannungsbegrenzendes Bauelement. Eine Kontrolle der Funktionstüchtigkeit und des Zustandes des Überspannungsschutzelements während des Betriebs wird dadurch ermöglicht, dass die Suppressor-Diode im Brückenzweig einer Dioden-Brückenschaltung angeordnet ist und dass an die Suppressor-Diode ein Kapazitäts-Messgerät angeschlossen ist, wobei durch das Kapazitäts-Messgerät die Kapazität bzw. eine Kapazitätsänderung der Suppressor-Diode erfasst wird.

Es wurde erkannt, dass sich daraus die Aufgabe ergibt, Möglichkeiten vorzusehen, mit der sich auch diese Niedervoltleitungen im Hinblick auf gefährliche Hochvoltpotentiale sichern lassen.

Diese Aufgabe wird gelöst durch die Gegenstände der unabhängigen Ansprüche. Weitere Eigenschaften, Merkmale, Ausführungsformen und Vorteile ergeben sich mit den abhängigen Ansprüchen, der Beschreibung und der Figur.

Es wird vorgeschlagen, eine Fahrzeugbordnetz-Hochvoltschutzvorrichtung vorzusehen, die mittels Varistoren oder anderer Spannungsbegrenzungselemente vor Hochvoltpotentialen schützt. Zum einen kann dies geschehen, indem die Varistoren (oder die anderen Spannungsbegrenzungselemente) selbst gefährliche Hochvoltpotentiale zu einem Bezugspotential ableiten, und/oder indem mittels der Varistoren (oder anderer Spannungsbegrenzungselemente) ein Stromfluss vorgesehen wird, der durch gefährliche Hochvoltpotentiale (an einer Niedervoltleitung) veranlasst wird, sodass dieser Stromfluss durch weitere Maßnahmen, etwa durch Isolationswächter, sicher erfasst werden kann. Hierbei dienen die Varistoren (oder die anderen Spannungsbegrenzungselemente) zur Absicherung, indem diese zu leiten beginnen, wenn ein Hochvoltpotential an einer Stelle des Bordnetzes erscheint, an dem dieses in fehlerfreiem Zustand nicht auftreten würde.

Die Varistoren und die anderen Spannungsbegrenzungselemente haben als Bauelement die Eigenschaft, zu leiten, wenn eine über dem betreffenden Bauelement anliegende Spannung über oberhalb einer Grenzspannung (oder Durchbruchsspannung) liegt, und ansonsten nicht zu leiten. Diese Grenzspannung liegt beispielsweise über 20 V oder 40 V. Ferner haben diese Bauelemente die Eigenschaft, in fehlerhaftem Zustand, etwa nach einer Überlastung oder nach Überschreitung einer Alterungsgrenze, andere kapazitive Eigenschaften zu haben, als in fehlerfreiem Zustand (bei der etwa der Kapazitätsnennwert vorliegt). Diese Bauelemente können vorgesehen werden durch einen Varistor (wie erwähnt), oder können vorgesehen werden durch ein Spannungsbegrenzungselement wie ein Gasableiter, eine Funkenstrecke, eine Schutzdiode, eine Thyristorschaltung, einen DIAC, eine Zener-Diode und/oder eine Vierschichtdiode. Im Folgenden sind Eigenschaften, Merkmale und Ausführungsformen beschrieben, die sowohl für den dort genannten Varistor als auch für die anderen Spannungsbegrenzungselemente zutreffen. Insbesondere wird der Begriff "Varistor" stellvertretend verwendet für: ein Varistor(-bauelement), ein Gasableiter, eine Funkenstrecke, eine Schutzdiode, eine Thyristorschaltung, einen DIAC, eine Zener-Diode und/oder eine Vierschichtdiode oder auch andere Bauelemente mit den eingangs erwähnten Eigenschaften.

Maßgeblich für die Absicherung ist die genannte Funktion der Varistoren, sodass gemäß des Anspruchsgegenstands die Funktionsfähigkeit dieser Varistoren überprüft wird. Dies wird ausgeführt, indem die Kapazität der Varistoren und des Varistors ermittelt wird, da anhand der Kapazität ermittelt werden kann, ob sich der Varistor in fehlerhaftem oder in fehlerfreiem Zustand befindet. Die Kapazität in fehlerfreiem Zustand ist etwa aus Datenblättern des Varistors bekannt und somit eine bekannte Eigenschaft des Varistors. Wird bei einer hohen Spannung ein Varistor angelegt, bei der dieser leitet, so kann der Varistor etwa durch einen zu hohen Durchflussstrom (d.h. höher als der Maximalstrom gemäß Auslegung) einen Schaden erleiden, der dazu führt, dass dieser nicht korrekt arbeitet. Mit Spannungen unterhalb der Schwellenspannung des Varistors lässt sich dies nicht sicher überprüfen, da bei zu geringen Spannungen (unterhalb des Schwellenwerts) der Varistor nicht leitet und in fehlerhaftem Zustand der Varistor ebenso (unabhängig von der angelegten Spannung) einen hohen Widerstand aufweist.

Eine Überprüfung mittels hoher Spannungen (über der Schwellenspannung) birgt das Risiko einer gefährlichen Berührspannung.

Mittels der hier vorgeschlagenen Kapazitätsüberprüfung kann jedoch die Funktionsfähigkeit des Varistors ermittelt werden, ohne dass eine hohe Prüfspannung oberhalb des Schwellenwerts angelegt werden müsste, um so die dann einsetzende Leitung (in fehlerfreiem Zustand) zu überprüfen.

Es wird daher ein Verfahren zur Überprüfung der Funktionsfähigkeit einer Fahrzeugbordnetz-Hochvoltschutzvorrichtung (kurz: Schutzschaltung) beschrieben, die einen Varistor aufweist. Das Verfahren wird an einem Varistor (oder Spannungsbegrenzungselement) ausgeführt wird, über den das Potential einer Niedervoltleitung, die aus einem Hochvoltbereich herausgeführt ist, mit einem Masseanschluss der Fahrzeug-Hochvoltspannungsschutzschaltung verbunden, und der Hochvoltbereich durch eine Isolation von einem Niedervoltbereich getrennt ist, in welchem sich die Fahrzeug-Hochvoltspannungsschutzschaltung befindet, und der Masseanschluss der Fahrzeug-Hochvoltspannungsschutzschaltung ist mit einem Massepotential des Niedervoltbereichs verbunden ist und das Massepotential ist galvanisch getrennt von dem Hochvoltbereich.

Hierbei wird die Kapazität des Varistors bestimmt, wobei sich anhand dieser Kapazität ableiten lässt, ob der Varistor funktioniert oder nicht bzw. ob sich dieser in einem fehlerhaften oder in einem fehlerfreien Zustand befindet. Es wird somit der kapazitive Anteil der Wechselstromimpedanz des Varistors erfasst. Nachdem dieser erfasst wurde, etwa durch aktives Messen, wird dieser erfasste kapazitive Anteil ausgewertet und insbesondere mit einem Kapazitätsnennwert verglichen. Hierbei kann bspw. die Differenz gebildet werden zwischen dem erfassten kapazitiven Anteil und dem Kapazitätsnennwert (der bei fehlerfreiem Zustand von dem Varistor vorgesehen wird) oder es wird der kapazitive Anteil mit einem Kapazitätsintervall verglichen, dass einen Bereich kennzeichnet, den der Varistor in fehlerfreiem Zustand aufweist (etwa unter Berücksichtigung der Exemplarstreuung). Der Kapazitätsnennwert kennzeichnet die Kapazität eines funktionierenden Varistors, d.h. eines Varistors in fehlerfreiem Zustand; ein entsprechendes Intervall würde die Kapazität bzw. den Kapazitätsbereich eines funktionierenden Varistors kennzeichnen.

Der fehlerhafte Zustand des Varistors wird festgestellt, wenn der Vergleich ergibt, dass der kapazitive Anteil um mehr als um einen vorgegebenen Betrag von dem Kapazitäts-Nennwert abweicht. Dieser Nennwert kann bspw. auch gegeben sein durch die Grenzen eines Kapazitätsintervalls, welches die Kapazität eines funktionierenden Varistors kennzeichnet. In diesem Fall entspricht der Vergleich mit den Grenzen einem Vergleich des erfassten kapazitiven Anteils mit dem Intervall, das von den Grenzen definiert wird. Im Folgenden wird vereinfachend von einem Vergleich mit einem Kapazitäts-Nennwert gesprochen, wobei dies der Vergleich mit einem einzelnen Wert betreffen kann oder auch den Vergleich mit Grenzen eines Intervalls, das einen funktionierenden Varistor wiedergibt, oder mit Werten innerhalb dieses Intervalls.

Der vorgegebene Betrag gibt wieder, wie sehr der Anteil von dem Kapazitäts-Nennwert noch abweichen kann, um dennoch zu einem fehlerfreien Zustand zu gelangen bzw. gibt die Grenze wieder, bei deren Überschreiten von fehlerhaftem Varistor auszugehen ist. Der Betrag dient auch zur Berücksichtigung von Erfassungsfehlern oder Messfehlern sowie von Exemplarstreuungen des Varistors, um zu vermeiden, dass aufgrund von üblichen Mess- oder Erfassungsfehlern oder bei einer üblichen Streuung des Nenn-Kapazitätswerts nicht fälschlicherweise von einem fehlerhaften Varistor ausgegangen wird.

Das Erfassen kann durchgeführt werden durch einen aktiven Messvorgang, bei dem ein Wechselstromsignal an den Varistor angelegt wird, und bei dem das Wechselspannungssignal erfasst wird, das dadurch am Varistor erzeugt wird. Die Kapazität, d.h. der kapazitive Anteil, ergibt sich durch das Verhältnis des angelegten Wechselstromsignals zum Wechselspannungssignal in bekannter Weise. Auch eine hierzu komplementäre Messung ist möglich, bei der ein Wechselspannungssignal an den Varistor angelegt wird, und das am Varistor anliegende zugehörige Wechselstromsignal erfasst wird. Beim Anlegen eines Wechselstromsignals kann die direkt am Varistor anliegende Wechselspannung ermittelt werden, oder es kann eine Spannung ermittelt werden, die mit der am Varistor anliegenden Spannung variiert bzw. von dieser abhängt, um hieraus das Wechselspannungssignal zu bilden. Beim Anliegen eines Wechselspannungssignal an den Varistor kann das Wechselstromsignal erfasst werden, indem der durch den Varistor selbst fließende Strom erfasst wird, oder indem anhand eines Shunt-Widerstands zur Strommessung der Strom ermittelt wird, indem die am Shunt anliegende Spannung ermittelt wird, welche dem Wechselstrom entspricht. Es können sowohl das Wechselspannungssignal als auch das Wechselstromsignal direkte Messsignale sein oder es können hieraus abgeleitete Signale sein, insbesondere unter Verwendung von Verstärkern, Spannungsteilern, Shunt-Widerstände oder Ähnliches.

Wie erwähnt kann der kapazitive Anteil aktiv gemessen werden, d.h. Anlegen eines Anregungssignals (Anlegen eines Wechselstromsignals oder eines Wechselspannungssignals) und durch Erfassen eines sich daraus ergebenden Wechselspannungssignals bzw. Wechselstromsignals, das die Reaktion auf das Anregungssignal wiedergibt. Bei mehreren Varistoren kann für jeden Varistor eine eigene Einrichtung zur aktiven Erfassung vorgesehen sein, oder es kann durch Multiplexen ein- und dieselbe Erfassungseinrichtung verwendet werden, wobei diese gemeinsame Einrichtung abwechselnd bzw. nacheinander an die verschiedenen Varistoren angeschlossen wird, um deren kapazitiven Anteil zu messen. Die kapazitiven Anteile der Varistoren können somit mit individuellen Einrichtungen (bspw. eine pro Varistor) erfasst werden. Für jeden Varistor oder für eine Untergruppe hiervon kann eine eigene Signalquelle (Strom- oder Spannungsquelle für das anzulegende Wechselspannungs- oder Wechselstromsignals) vorgesehen sein. Alternativ oder in Kombination hiermit kann für jeden Varistor oder für eine Untergruppe hiervon eine eigene Messeinrichtung vorgesehen sein, die das sich ergebende Signal (Wechselspannungssignal beim Anlegen eines Wechselstroms und Wechselstromsignal beim Anlegen einer Wechselspannung) erfasst. Somit besteht dann für jeden Varistor oder für eine Untergruppe hiervon eine eigene Messeinrichtung, die das sich ergebende Signal erfasst, das am zugehörigen Varistor besteht.

Im Weiteren wird eine Möglichkeit beschrieben, bei der die kapazitiven Anteile mehrerer Varistoren durch Signalmultiplexing erfasst werden. Hierbei wird mit der gleichen Einrichtung der kapazitive Anteil mehrerer oder aller Varistoren erfasst, insbesondere nacheinander unter Verwendung von Signalmultiplexing. Es kann vorgesehen sein, dass dieselbe Signalquelle ein Wechselstromsignal an alle Varistoren oder an eine Untergruppe hiervon anlegt. Dies kann über eine Multiplexingvorrichtung geschehen, d.h. nacheinander, oder es kann das Wechselstromsignal (oder das Wechselspannungssignal) an alle Varistoren oder an eine Untergruppe hiervon gleichzeitig angelegt werden. Alternativ oder in Kombination hiermit kann für alle Varistoren oder für eine Untergruppe hiervon dieselbe Messeinrichtung das sich ergebende Signal an den Varistoren erfassen, d.h. an allen Varistoren oder er Untergruppe hiervon, insbesondere nacheinander. Bei der Erfassung der sich ergebenden Signale der Varistoren nacheinander wird vorzugsweise auch beim Messen ein Signalmultiplexing verwendet. Zudem kann dieselbe Einrichtung das sich ergebende Signal an allen Varistoren oder einer Untergruppe hiervon gleichzeitig erfassen (ohne Signalmultiplexing), da dadurch auch bei mehreren Varistoren ein stark erhöhter kapazitiver Anteil ermittelt werden kann, um so festzustellen, dass zumindest einer der Varistoren fehlerhaft ist. Dadurch wäre kein Signalmultiplexing erforderlich. Bei der Verwendung von Signalmultiplexing, insbesondere beim Messen, ergibt sich der Vorteil, dass nicht nur erkannt wird, dass mindestens einer der Varistoren fehlerhaft ist, sondern dass auch erkannt werden kann, welcher Varistor fehlerhaft ist. Die Erfassung wäre daher varistorbezogen, und nicht bezogen auf eine Untergruppe oder auf alle Varistoren.

Das Verfahren wird an einem Varistor ausgeführt, über den das Potential einer Niedervoltleitung mit einer Fahrzeugbordnetzmasse verbunden ist. Diese Niedervoltleitung ist aus dem Hochvoltbereich herausgeführt und kann so bei Fehlern der Isolation innerhalb des Hochvoltbereichs eine zu hohe Spannung führen (gegenüber Masse), so dass der Varistor ausgelöst wird (d.h. teilweise oder vollständig leitend wird). Dies betrifft insbesondere den Varistor bzw. alle Varistoren, deren kapazitiver Anteil erfasst wird. Insbesondere betrifft dies die Varistoren, deren erfasster kapazitiver Anteil verglichen wird mit einem Kapazitäts-Nennwert. Mit anderen Worten ist derjenige Varistor, dessen Zustand festgestellt wird, vorzugsweise mit einem Bezugspotential wie der Fahrzeugbordnetzmasse verbunden. Diese Verbindung ist vorzugsweise indirekt, d.h. führt über mindestens eine Impedanz, die insbesondere induktiv ist und/oder einen ohmschen Anteil aufweist. Somit kann das Verfahren an einem Varistor ausgeführt werden, der über eine Induktivität und/oder über einen Widerstand mit dem Bezugspotential (etwa Fahrzeugbordnetzmasse) verbunden ist. Insbesondere bei einer Anbindung des Varistors, an dem das Verfahren ausgeführt wird, über eine Schaltung oder eine Impedanz, die einen induktiven Anteil aufweist, ergibt sich vom Varistor aus gesehen zur Fahrzeugbordnetzmasse hin ein Tiefpass. Ausführungsformen sehen daher vor, den oder die Varistoren über einen Tiefpass bzw. über einen Filter mit einer Dämpfung, die mit der Frequenz zunimmt, Hochsperre mit dem Bezugspotential zu verbinden. Dadurch kann das (aktive) Erfassen des kapazitiven Anteils der Wechselstromimpedanz des Varistors unter Abtrennung des Bezugspotentials von dieser Erfassung durchgeführt werden, indem die Induktivität die von der aktiven Erfassung verursachten Wechselanteile gegenüber dem Bezugspotential abblockt. Mit anderen Worten wird der kapazitive Anteil der Wechselstromimpedanz des Varistors vorzugsweise durch eine Schaltung (aktiv) erfasst, zwischen der und der Fahrzeugbordnetzmasse eine hierzu seriell geschaltete Impedanz vorliegt, die Wechselspannungs- oder Wechselstromsignale zur Fahrzeugbordnetzmasse hin dämpft. Bei der Erfassung des kapazitiven Anteils wird vorzugsweise ein Wechselsignal verwendet, dessen Frequenz derart ausgestaltet ist, dass die genannte Impedanz eine frequenzabhängige Dämpfung von mindestens 10, 30 oder 50 dB bei dieser Frequenz erzeugt. Entsprechend ist auch die Impedanz ausgebildet (im Bezug zu der verwendeten Frequenz des Wechselsignals). Die Frequenz kann mehr als 1 kHz, 10 kHz, vorzugsweise mindestens 100 kHz, 1 MHz oder 5 MHz.

Im Weiteren wird eine Fahrzeug-Hochvoltspannungsschutzschaltung beschrieben, die insbesondere zur Ausführung des hier beschriebenen Verfahrens geeignet ist. Die Fahrzeug-Hochvoltspannungsschutzschaltung (kurz: Schutzschaltung) umfasst mindestens einen Schutzanschluss, der eingerichtet ist zur Verbindung mit einer Niedervoltleitung, welche aus einem Hochvoltbereich herausgeführt ist. Die Schutzschaltung umfasst ferner mindestens einen Varistor. Über diesen Varistor ist der Schutzanschluss mit einem Masseanschluss der Fahrzeug-Hochvoltspannungsschutzschaltung verbunden. Als Masseanschluss wird hierbei allgemein ein Bezugspotential bezeichnet, dass dem Fahrzeugchassis zuzuordnen ist. Dies gilt auch für die Fahrzeugbordnetzmasse. Der hier erwähnte Masseanschluss wird insbesondere die Fahrzeugbordnetzmasse oder, allgemein, ein bordnetzbezogenes Bezugspotential.

Die Schutzschaltung weist zudem eine Erfassungseinrichtung auf. Diese ist signalübertragend mit dem Varistor verbunden. Als signalübertragende Verbindung kann eine direkte leitungsbezogene Verbindung bezeichnet werden, oder auch Verbindungen über Filter, kapazitive Ankopplungen und/oder Spannungsteiler oder Verstärker. Die Erfassungseinrichtung ist eingerichtet, den kapazitiven Anteil der Wechselstromimpedanz des Varistors zu erfassen, insbesondere auf Grund der signalübertragenden Verbindung mit dem Varistor. Ferner weist die Schutzschaltung eine Auswerteeinrichtung auf. Diese ist der Erfassungseinrichtung nachgeschaltet. Die Auswerteeinrichtung ist eingerichtet, den von der Erfassungseinrichtung erfassten kapazitiven Anteil mit einem Kapazitäts-Nennwert des Varistors zu vergleichen. Ferner ist diese Auswerteeinrichtung eingerichtet, bei einer Abweichung, die einen vorgegebenen Betrag übersteigt, an einem Signalausgang der Auswerteeinrichtung ein Fehlersignal abzugeben. Dieses kennzeichnet den Varistor als fehlerhaft. Die Erfassungseinrichtung ist somit ausgebildet zur Ausführung des hier beschriebenen Schritts des Erfassens des kapazitiven Anteils. Allgemein ist die Auswerteeinrichtung eingerichtet, den von der Erfassungseinrichtung erfassten kapazitiven Anteil wie beschrieben zu vergleichen.

Hierbei muss dieser nicht notwendigerweise der Erfassungseinrichtung nachgeschaltet sein, sondern kann auch Teil dieser Erfassungseinrichtung sein und beispielsweise einer Entität nachgeschaltet sein, die eingerichtet ist, den kapazitiven Anteil der Wechselstromimpedanz des Varistors zu erfassen, etwa einer Messeinrichtung. Gemäß einer Ausführungsform umfasst die Erfassungseinrichtung sowohl mindestens eine Messeinrichtung als auch eine Wechselsignalquelle und zudem einen Vergleicher, der den Schritt des Vergleichens ausführt, und der entsprechend das Signal abgeben kann, welches einen fehlerhaften Zustand kennzeichnet.

Auch bei der Schutzschaltung kann eine Wechselstromquelle oder eine Wechselspannungsquelle verwendet werden, wie vorangehend anhand des Verfahrens beschrieben ist. Umfasst die Schutzschaltung eine Wechselstromquelle, dann ist diese mit dem mindestens einen Varistor (signalübertragend) verbunden und eingerichtet, einen Wechselstrom am Varistor einzuprägen. Somit dient der Wechselstrom zur Anregung. Die Erfassungseinrichtung oder eine Messeinrichtung hiervon ist mit dem Varistor signalübertragend verbunden und ist eingerichtet, die Spannung zu erfassen, die sich durch den eingeprägten Wechselstrom am Varistor (als Reaktion) ergibt. Hierbei kann die Wechselstromquelle ein Teil der Erfassungseinrichtung sein, oder ist eine Wechselstromquelle außerhalb der Erfassungseinrichtung (die eine Messeinrichtung und ggf. eine Vergleichseinrichtung aufweist).

Alternativ kann zur Anregung, das heißt zur aktiven Messung, eine Wechselspannungsquelle verwendet werden. Diese ist mit dem mindestens einen Varistor signalübertragend verbunden. Ferner ist die Wechselspannungsquelle eingerichtet, eine Wechselspannung an den Varistor anzulegen, der direkt oder indirekt über eine kapazitive Ankopplung, ein Widerstandsnetzwerk und/oder über einen Verstärker mit der Quelle verbunden ist. Die Erfassungseinrichtung ist ebenso mit dem Varistor (signalübertragend) verbunden. Die Erfassungseinrichtung ist eingerichtet, den Strom zu erfassen, der sich durch die angelegte Wechselspannung am Varistor ergibt. Die Wechselspannungsquelle kann Teil der Erfassungseinrichtung sein (die ferner eine Messeinrichtung und/oder eine Vergleichseinrichtung wie einen Komparator umfassen kann). Alternativ ist die Wechselspannungsquelle extern von der Erfassungseinrichtung vorgesehen.

In spezifischen Ausführungsformen sieht das (aktive) Erfassen des kapazitiven Anteils des Varistors vor, dass dieser mittels eines Wechselsignals angeregt wird, welches von einer Kommunikationseinheit stammt, die mit der Niedervoltleitung verbunden ist, an die auch der Varistor angeschlossen ist. Hierbei dient etwa ein Kommunikationssignal (Sensorsignal, Steuersignal, ...) zur Anregung des Varistors, wobei das Kommunikationssignal übermittelt wird bei der Ausführung eines Sensorauswertungsverfahrens, eines Steuer- oder Regelverfahrens oder eines Verfahrens zur Versorgung von Niedervoltkomponenten mit Niedervoltspannung. Die Signalquelle für das Wechselsignal (das heißt die Wechselstromquelle oder die Wechselspannungsquelle) wäre in diesem Fall dann nicht eine dezidierte Signalquelle, sondern wäre eine Steuereinheit, Sensoreinheit oder ähnliches, die eine weitere Funktion erfüllt und mit der Niedervoltleitung verbunden ist, an der auch der Varistor angeschlossen ist. Daher sollen die Begriffe Wechselstromquelle und Wechselstromquelle sowohl dezidierte Wechselsignalquellen als auch Wechselsignalquellen bezeichnen, die eine weitere Funktion aufweisen und im Rahmen dieser Funktion ein Wechselsignal erzeugen, etwa ein Datensignal, Kommunikationssignal, Steuersignal, Sensorsignal oder ähnliches. Auch eine Niedervoltstromversorgungsschaltung, die über die Niedervoltleitung übertragen wird, kann dieses Wechselsignal zur Erfassung des kapazitiven Anteils vorsehen, insbesondere, wenn dieses Wechselsignal im Hochvoltabschnitt zur Energieversorgung verwendet wird, etwa einer Niedervoltkomponente.

In diesem Fall wäre daher zur Ausführung der Schutzschaltung bzw. zur Ausführung des hier beschriebenen Verfahrens nur notwendig, dass zu einer bestehenden Vorrichtung eine passive Erfassungseinrichtung hinzugefügt wird, das heißt eine Erfassungseinrichtung, die nicht über eine eigene Signalquelle verfügt, sondern die eine Messeinheit und/oder eine Auswerteeinheit aufweist.

Die Schutzschaltung kann mehrere Varistoren umfassen. Hierbei kann für jeden Varistor, oder für eine Untergruppe hiervon, eine Erfassungseinrichtung vorgesehen sein. Diese ist signalübertragend mit dem jeweiligen Varistor verbunden. Dies kann auch nur für eine Messeinrichtung der Erfassungseinrichtung vorgesehen sein bzw. für eine Messeinrichtung, die der Erfassungsvorrichtung zugeordnet ist. In diesem Fall besteht eine feste Zuordnung zwischen Varistor und Erfassungseinrichtung. Alternativ kann ein Auswahlschalter vorgesehen sein, über den die Erfassungseinrichtung (oder dessen Messeinrichtung) mit allen Varistoren oder mit einer Untergruppe hiervon verbunden ist. Hierbei ist der Auswahlschalter eingerichtet, die Erfassungseinrichtung mit einem ausgewählten Varistor oder mit einer ausgewählten Untergruppe von Varistoren zu verbinden. Der Auswahlschalter ist somit eingerichtet, unter den Varistoren oder von den Untergruppen ein Element (Varistor oder Untergruppe) von mehreren auszuwählen, um dieses Element mit der Erfassungseinrichtung zu verbinden. Die Erfassungseinrichtung ist dann in der Lage, nacheinander die jeweiligen kapazitiven Anteile der verschiedenen Varistoren oder der verschiedenen Untergruppen der Varistoren zu ermitteln. Mittels des Auswahlschalters wird das Signalmultiplexing ausgeführt. Insbesondere ist der Auswahlschalter eingerichtet, die Wechselstrom- oder Wechselspannungs-Signalquelle nacheinander mit unterschiedlichen Varistoren oder unterschiedlichen Untergruppen zu verbinden. Es kann auch eine gemeinsame Signalquelle vorgesehen sein, die das Wechselsignal (Wechselstrom oder Wechselspannung) an alle Varistoren oder an alle Untergruppen anlegt, während nur die Erfassungseinrichtung über den Auswahlschalter die einzelnen Varistoren oder Untergruppen auswählen kann.

Der mindestens eine Varistor ist vorzugsweise über einen Hochpassfilter mit dem Masseanschluss verbunden. Dadurch wird vermieden, dass das zur aktiven Messung vorgesehene Wechselsignal (Wechselstrom oder Wechselspannung) zum Masseanschluss hin abgeführt wird bzw. über den Masseanschluss in weitere Komponenten des Fahrzeugbordnetzes dringt. In einer Ausführungsform ist der mindestens eine Varistor über eine Induktivität und/oder über einen Widerstand mit dem Masseanschluss verbunden. Auch die Verwendung eines Widerstands sieht eine Dämpfung von Wechselstrom- oder Wechselspannungskomponenten bei der Übertragung zum Masseanschluss vor.

Wie erwähnt dient das hier beschriebene Verfahren und die hier beschriebenen Vorrichtungen zum Schutz von mindestens einer Niedervoltleitung, die aus einem Hochvoltbereich herausgeführt ist. Hierbei ist der Hochvoltbereich in einem abgeschlossenen Gehäuse vorgesehen. Aus diesem heraus werden Niedervoltleitungen geführt, etwa zur Steuerung oder zur Zensierung oder auch zur Versorgung (Niedervolt) von Komponenten innerhalb des Hochvoltbereichs.

Insbesondere durchdringt die mindestens eine Niedervoltleitung die Gehäusewand, die den Hochvoltbereich räumlich abschließt. Mit anderen Worten durchdringt die mindestens eine Niedervoltleitung die Begrenzung, mittels der der Hochvoltbereich räumlich begrenzt ist, insbesondere gegenüber dem Niedervoltbereich bzw. der Umgebung des Hochvoltbereichs. Die mindestens eine Niedervoltleitung durchdringt in einer Ausführungsform eine Isolation, welche den Hochvoltabschnitt von dem Niedervoltabschnitt trennt.

Im Weiteren wird dies beispielhaft anhand eines Hochvolt-Fahrzeugbordnetzes näher beschrieben.

Es wird ein Hochvolt-Fahrzeugbordnetz mit einem räumlich begrenzten Hochvoltbereich vorgesehen, aus dem mindestens eine Niedervoltleitung herausgeführt ist. Die mindestens eine Niedervoltleitung durchdringt hierbei die räumliche Begrenzung des Hochvoltbereichs. Diese Begrenzung trennt den Hochvoltbereich von der Umgebung, insbesondere von einem Niedervoltbereich. Die Niedervoltleitung kann hierbei vom Hochvoltbereich in den Niedervoltbereich führen. Ist eine Hochvoltspannungs-Schutzschaltung vorgesehen, wie sie hierin beschrieben ist, dann ist der mindestens eine Schutzanschluss dieser Schutzschaltung mit der mindestens einen Niedervoltleitung verbunden. Sind mehrere Niedervoltleitungen vorgesehen, dann weist die Schutzschaltung vorzugsweise Schutzanschlüsse in mindestens der gleichen Anzahl auf, so dass für jede Niedervoltleitung ein individueller Schutzanschluss vorgesehen ist.

Der Hochvoltbereich ist mittels einer Isolation vor dem Niedervoltbereich getrennt. Mit anderen Worten ist die mindestens eine Niedervoltleitung durch diese Isolation hindurch aus dem Hochvoltbereich herausgeführt. Die Isolation kann vorgesehen werden durch die räumliche Begrenzung des Hochvoltbereichs bzw. von einem Gehäuse oder einer Umschließung des Hochvoltbereichs. In dem Niedervoltbereich befindet sich die genannte Schutzschaltung. Der Niedervoltbereich weist ein Massepotential auf, beispielsweise das Potential des Chassis, wobei der Masseanschluss der Schutzschaltung mit diesem Potential verbunden ist. Das Massepotential ist getrennt von dem Hochvoltbereich vorgesehen.

Der Schutzanschluss bzw. die Niedervoltleitung ist galvanisch mit dem Massepotential verbunden. Aus diesem Grund kann über den Varistor ein Isolationsfehler bzw. eine mangelhafte galvanische Trennung zwischen Hochvoltbereich und Niedervoltbereich einerseits und Niedervoltbereich bzw. Massepotential oder Masseanschluss andererseits erfasst werden.

Die Niedervoltleitung kann als Sensorleitung vorgesehen sein. Insbesondere kann die Niedervoltleitung zu einem Sensor innerhalb des Hochvoltbereichs führen. Derartige Komponenten sind beispielsweise als Temperatursensor, Spannungssensor, Stromsensor, Drucksensor oder ähnliches ausgebildet. Die Niedervoltleitung kann ferner eine Datenleitung sein, insbesondere eine Datenleitung zur Kommunikation mit Komponenten innerhalb des Hochvoltbereichs. Beispielsweise kann die Datenleitung eine Steuerleitung sein, um eine Komponente innerhalb des Hochvoltbereichs vom Niedervoltbereich aus anzusteuern. Auch umgekehrt kann die Datenleitung dazu dienen, dass eine Komponente innerhalb des Hochvoltbereichs eine Komponente innerhalb des Niedervoltbereichs ansteuert, oder allgemein mit dieser kommuniziert, beispielsweise auch um Sensordaten zu übertragen. Beispiele hierfür sind beispielsweise die Kommunikation zwischen einem Batteriemanagementsystem innerhalb des Hochvoltbereichs, das mit einer Komponente des Niedervoltbereichs kommuniziert.

Schließlich kann die Niedervoltleitung eine Niedervolt-Versorgungsleitung sein, die von einer Komponente des Hochvoltbereichs zum Niedervoltbereich führt, um von diesem aus mit einer Niedervoltspannung versorgt zu werden. Beispiele hierfür sind Niedervolt-Spannungsquellen, die über eine Niedervoltleitung in Form einer Niedervolt-Versorgungsleitung mit einem Sensor oder einer Kommunikationskomponente innerhalb des Hochvoltbereichs verbunden sind, und eingerichtet sind, diese Komponente innerhalb des Hochvoltbereichs zu versorgen. Diesen Leitungen ist gemeinsam, dass sie im fehlerfreien Betrieb, das heißt bei fehlerfreier Isolation bzw. galvanischer Trennung gegenüber dem Massepotential bzw. dem Masseanschluss eine Spannung aufweisen, die kleiner ist als 60 V (insbesondere kleiner als 24 V). Beispielsweise können die Datenleitungen Spannungen führen, die zwischen 0 und 5 V oder zwischen 0 und 12 V variieren. Dies gilt auch für die Versorgungsleitung. Ausführungsformen sehen vor, dass mehrere Niedervoltleitungen vorgesehen sind, wobei von diesen ein oder mehrere Sensorleitungen sind, ein oder mehrere Datenleitungen sind und/oder ein oder mehrere Niedervolt-Versorgungsleitungen sind.

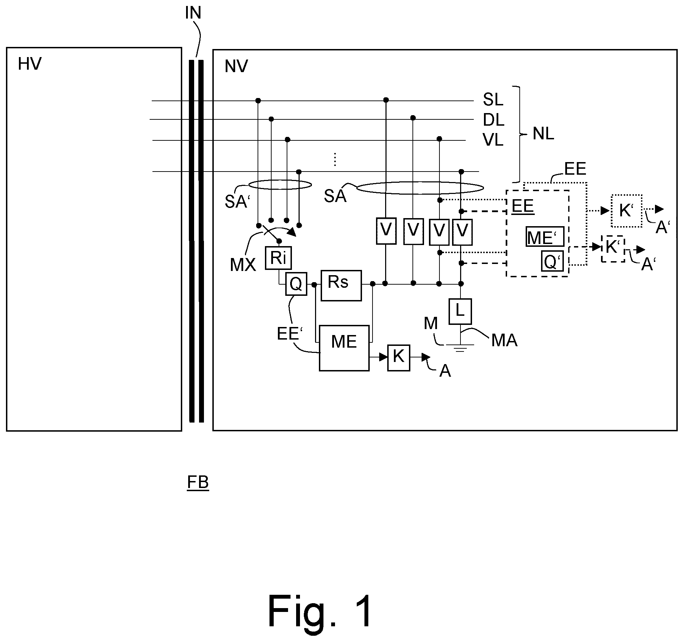

Die Figur 1 zeigt ein Hochvolt-Fahrzeugbordnetz mit einer erfindungsgemäßen Schutzschaltung zur näheren Erläuterung von Ausführungsformen der hier beschriebenen Gegenstände.

Das Hochvolt-Fahrzeugbordnetz FB der Figur 1 weist einen räumlich begrenzten Hochvoltbereich HV, der über eine Isolation IN an einen Niedervoltbereich angrenzt. Es bestehen Niedervoltleitungen NL innerhalb des Niedervoltbereichs NV, die aus dem Hochvoltbereich herausgeführt sind, die Isolation IN durchdringen, insbesondere auch ein Gehäuse, in dem sich der Hochvoltbereich HV befindet, und die in den Niedervoltbereich NV hineingeführt sind. Die Komponenten, die mittels der Niedervoltleitungen NL miteinander verbunden sind, sind zur besseren Übersicht nicht dargestellt. Jedoch kann allgemein davon ausgegangen werden, dass die dargestellten Niedervoltleitungen mindestens eine Komponente des Niedervoltbereichs NV mit mindestens einer Komponente des Hochvoltbereichs HV verbinden.

Die Niedervoltleitungen NL sind beispielhaft als Signalleitung SL, Datenleitung DL und Versorgungsleitung VL dargestellt, wobei die unterste Leitung der Leitungen NL auch eine Kommunikationsleitung sein kann.

Das Hochvolt-Fahrzeugbordnetz FB der Figur 1 ist ferner mit einer Fahrzeug-Hochvoltspannungsschutzschaltung (kurz: Schutzschaltung) ausgestattet. Diese weist zur Verbindung mit den Niedervoltleitungen NL mehrere Schutzanschlüsse SA, SA' auf. Die Schutzanschlüsse dienen zur Anbindung an die einzelnen Niedervoltleitungen und dienen ferner zum Anschluss von Varistoren V der Schutzschaltung. Die Varistoren der Figur 1 sind jeweils einer bestimmten Niedervoltleitung NL zugeordnet bzw. einem spezifischen Schutzanschluss SA. Auf der den Schutzanschlüssen abgewandten Seite sind die Varistoren V mit einem Masseanschluss MA der Schutzschaltung verbunden, insbesondere über die dargestellte Induktivität L. Diese verhindert, dass bei der aktiven Messung Wechselspannungs- oder Wechselstromanteile, die bei der Messung verwendet werden, zum Masseanschluss MA bzw. zum Massepotential M des Niedervoltbereichs gelangen. Der Masseanschluss MA der Schutzschaltung ist, wie dargestellt, mit der Masse bzw. dem Massepotential M des Niedervoltbereichs NV verbunden. Die Induktivität bildet allgemein einen Tiefpass und verhindert so den Übergang von Wechselanteilen von der Schutzschaltung zu anderen Potentialen des Niedervoltbereichs NV.

Die Schutzschaltung kann mit einer Erfassungseinrichtung EE' ausgebildet sein, die zum einen eine Wechselstromquelle Q und zum anderen einen Schandwiderstand bzw. Messwiderstand Rs aufweist. Die Wechselstromquelle ist über den Messwiderstand Rs mit den Varistoren verbunden, insbesondere mit der Seite der Varistoren V, die den Schutzanschlüssen abgewandt ist. Eine Messeinrichtung ME ist parallel zu dem Messwiderstand Rs vorgesehen. Diese kann im dargestellten Beispiel als Spannungsmesseinrichtung vorgesehen sein. Diese misst die Spannung, die entsteht, wenn die Wechselstromquelle Q ein Wechselstromsignal über den Messwiderstand Rs an die Varistoren V anlegt. Die Messeinrichtung ME gibt ein Signal ab, welches die Größe des kapazitiven Anteils des ausgewählten (gemessenen) Varistors V kennzeichnet. Diese Größe wird an den Komparator K weitergegeben, der der Messeinrichtung ME nachgeschaltet ist. Dieser vergleicht den Wert, der dem kapazitiven Anteil entspricht, mit einem vorgegebenen Wert, um so zu ermitteln, ob der kapazitive Anteil bzw. die gemessene Kapazität des betreffenden Varistors in einem Nennbereich liegt bzw. um nicht mehr als einen Betrag von einem Nennwert abweicht oder nicht. Das Ergebnis wird an den Ausgang A des Komparators abgegeben, wobei das Signal am Ausgang A wiedergibt, ob der betreffende Varistor V auf Grund des zu stark abweichenden kapazitiven Anteils als fehlerhaft zu kennzeichnen ist, oder nicht.

Zur Auswahl des Varistors V, der zu messen ist, ist ein Auswahlschalter MX vorgesehen, der (über einen Widerstand RI) mit der Stromquelle Q verbunden ist, und wahlweise so wie Quelle Q mit einem der Schutzanschlüsse SA' verbindet. Zur besseren Darstellung der Funktionalität sind die Schutzanschlüsse SA' getrennt von den Schutzanschlüssen SA dargestellt. Hierbei dienen die Schutzanschlüsse SA zur Anbindung der Varistoren an die Niedervoltleitungen NL und die Schutzanschlüsse SA' zur Anbindung der Erfassungseinrichtung EE' (bzw. dessen Wechselstromquelle Q) an die einzelnen Leitungen NL. Ferner dienen die Schutzanschlüsse SA' zur Anbindung der Messeinheit ME bzw. des zugehörigen Messwiderstands Rs an die Niedervoltleitungen NL (über den Auswahlschalter MX). Die Schutzanschlüsse SA' dienen somit der aktiven Erfassung bzw. Messung des kapazitiven Anteils der Varistoren V, die wiederum zur Ableitung von Strom bei zu hohen Spannungen der Niedervoltleitungen NL (gegenüber Masse) dienen. Es ist ersichtlich, dass die Schutzanschlüsse SA' und SA an dieselben Potentiale angeschlossen sind, so dass bei einer konkreten Ausführungsform innerhalb der Schutzschaltung die Schutzanschlüsse SA' und SA miteinander verbunden werden, um so einen gemeinsamen Schutzanschluss für die Niedervoltleitungen NL darzustellen. Dadurch muss jede Niedervoltleitung NL nur einmal kontaktiert werden.

Der Auswahlschalter MX dient zur Auswahl eines der Varistoren V. Im dargestellten Beispiel ist der Varistor V ausgewählt, der mit der Signalleitung SL verbunden ist. Über den Auswahlschalter MX wird dadurch ein Wechselstrom an diesen Varistor angelegt, während ebenfalls über den gleichen Auswahlschalter MX in gleicher Weise ausgewählt ist, dass die sich am betreffenden Varistor V ergebende Spannung über die Messeinheit ME erfasst wird. Ist die Quelle Q eine Wechselspannungsquelle, dann ergibt sich das gleiche Bild: Die Spannung wird über den Messwiderstand Rs einerseits und über den Auswahlschalter MX andererseits an den betreffenden Varistor angelegt, der an die Signalleitung SL angeschlossen ist. Mittels des Messwiderstands Rs wird der zugehörige Strom erfasst durch Erfassen der Spannung, die an diesen Widerstand Rs abfällt. Somit dient auch hier die Messeinheit zur Erfassung des Stroms über den Widerstand Rs. Alternativ kann die Messeinheit auch direkt die am Varistor V abfallende Spannung erfassen (wie durch Erfassungseinrichtung EE dargestellt). Unabhängig jedoch von der konkreten Ausgestaltung und Anknüpfung der Messeinheit ME erfasst diese entweder den durch den Varistor fließenden Strom mittels des als Schandwiderstand dienenden Messwiderstands Rs, oder misst eine Spannung, aus der sich die am Varistor V abfallende Spannung ableiten lässt.

Anstatt der Verwendung einer Erfassungseinrichtung EE' für alle Varistoren V durch Verwendung eines Auswahlschalters können auch Erfassungseinrichtungen, wie mit dem Bezugszeichen E dargestellt, vorgesehen werden. Auf der rechten Seite gestrichelt dargestellt ist eine erste Erfassungseinrichtung EE, die parallel an den am weitesten rechts dargestellten Varistor V angeschlossen ist. Eine weitere Erfassungseinrichtung EE, mit Punktlinien dargestellt, ist mit einer anderen Niedervoltleitung NL verbunden, nämlich mit der Leitung VL. Mit anderen Worten sind die verschiedenen dargestellten Erfassungseinrichtungen EE mit verschiedenen Varistoren verbunden, um die darüber abfallende Spannung zu messen. Jede Erfassungseinrichtung EE weist eine Messeinheit ME', mit der die am Varistor V abfallende Spannung erfasst wird, auf. Zudem weist jede der Erfassungseinrichtungen EE eine Quelle Q' auf, mittels der ein Wechselspannungssignal an den angeschlossenen Varistor V angelegt werden kann. Ist die Quelle Q eine Wechselstromquelle, dann erfasst die Messeinheit ME' die am angeschlossenen Varistor V abfallende Spannung. Ist die Quelle Q' eine Wechselspannungsquelle, dann erfasst die Messeinrichtung ME' den Strom, der zwischen Quelle und angeschlossenem Varistor fließt. Jede Erfassungseinrichtung EE ist eingerichtet, den kapazitiven Anteil des angeschlossenen Varistors zu errechnen, insbesondere durch Ermitteln des Verhältnisses von gemessenem oder eingeprägtem Strom zu abfallender Spannung bzw. angelegter Spannung. Dieses Ergebnis wird wie dargestellt an jeweilige Komparatoren K' weitergegeben, wobei deren jeweiligen Ausgänge A' ein Signal abgeben, dass kennzeichnet, ob der gemessene kapazitive Anteil um mehr als einen Betrag von einem Nennanteil abweicht, oder nicht. Ist die Abweichung größer als der vorgegebene Betrag, dann wird von einem fehlerhaften Varistor ausgegangen. Die Ausgänge A' können kombiniert werden, etwa mittels einer logischen ODER-Schaltung. Diese erfasst, ob mindestens ein Ausgang A' ein Signal abgibt, dass einen fehlerhaften Varistor kennzeichnet. Die ODER-Verknüpfung kann einen Gesamtausgang aufweisen, der angibt, ob mindestens einer der einzelnen Ausgänge A' einen fehlerhaften Varistor kennzeichnet, um so allgemein einen Fehler in der Schutzschaltung bzw. einen Fehler in der Gruppe der Varistoren zu kennzeichnen bzw. auszugeben.

## Patentansprüche

1. Verfahren zur Überprüfung der Funktionsfähigkeit einer Fahrzeugbordnetz-Hochvoltschutzvorrichtung, die einen Varistor oder ein anderes Spannungsbegrenzungselement aufweist, mit den Schritten:
- Erfassen des kapazitiven Anteils der Wechselstromimpedanz des Varistors beziehungsweise des Spannungsbegrenzungselements;
- Vergleichen des kapazitiven Anteils mit einem Kapazitäts-Nennwert, wobei der Kapazitäts-Nennwert die Kapazität eines funktionierenden Varistors beziehungsweise eines funktionierenden Spannungsbegrenzungselements kennzeichnet;
- Feststellen eines fehlerhaften Zustands des Varistors beziehungsweise des Spannungsbegrenzungselements, wenn der Vergleich ergibt, dass der kapazitive Anteil um mehr als einen vorgegebenen Betrag von dem Kapazitäts-Nennwert abweicht,
wobei das Verfahren an dem Varistor (V) beziehungsweise Spannungsbegrenzungselement ausgeführt wird, über den beziehungsweise das das Potential einer Niedervoltleitung (NV), die aus einem Hochvoltbereich (HV) herausgeführt ist, mit einem Masseanschluss (MA) der Fahrzeug-Hochvoltspannungsschutzschaltung verbunden ist, und der Hochvoltbereich durch eine Isolation von einem Niedervoltbereich (NV) getrennt ist, in welchem sich die Fahrzeug-Hochvoltspannungsschutzschaltung befindet, und der Masseanschluss (MA) der Fahrzeug-Hochvoltspannungsschutzschaltung mit einem Massepotential (M) des Niedervoltbereichs (NV) verbunden ist und das Massepotential (M) galvanisch getrennt ist von dem Hochvoltbereich (HV).

2. Verfahren nach Anspruch 1, wobei das Erfassen durchgeführt wird
(a) durch Anlegen eines Wechselstromsignals an den Varistor (V) beziehungsweise an das Spannungsbegrenzungselement und durch Erfassen des am Varistor (V) beziehungsweise am Spannungsbegrenzungselement anliegenden zugehörigen Wechselspannungssignals oder
(b) durch Anlegen eines Wechselspannungssignals an den Varistor (V) beziehungsweise an das Spannungsbegrenzungselement und durch Erfassen des am Varistor beziehungsweise am Spannungsbegrenzungselement anliegenden zugehörigen Wechselstromsignals.

3. Verfahren nach Anspruch 1 oder 2, wobei für mehrere Varistoren (V) beziehungsweise Spannungsbegrenzungselemente der jeweilige kapazitive Anteil der Wechselstromimpedanz erfasst wird und wobei
- die kapazitiven Anteile der Varistoren (V) beziehungsweise der Spannungsbegrenzungselemente mit individuellen Einrichtungen (EE) erfasst wird und für jeden Varistor (V) beziehungsweise für jedes Spannungsbegrenzungselement oder eine Untergruppe hiervon eine eigene Signalquelle (Q') ein Wechselstromsignal anlegt und/oder für jeden Varistor (V) beziehungsweise Spannungsbegrenzungselement oder eine Untergruppe hiervon eine eigene Messeinrichtung (ME') das sich ergebende Signal am zugehörigen Varistor (V) beziehungsweise am Spannungsbegrenzungselement erfasst, oder
- die kapazitiven Anteile der mehreren Varistoren (V) beziehungsweise Spannungsbegrenzungselemente durch Signalmultiplexing (SA') mit der gleichen Einrichtung (EE') erfasst werden und dieselbe Signalquelle (Q) ein Wechselstromsignal an alle Varistoren (V) beziehungsweise Spannungsbegrenzungselemente oder an eine Untergruppe hiervon anlegt und/oder für alle Varistoren (V) beziehungsweise Spannungsbegrenzungselemente oder für eine Untergruppe hiervon dieselbe Messeinrichtung (ME) das sich ergebende Signal an den Varistoren (V) beziehungsweise an den Spannungsbegrenzungselementen erfasst.

4. Verfahren nach einem der vorangehenden Ansprüche, wobei der Varistor (V) beziehungsweise das Spannungsbegrenzungselement, mit dem Masseanschluss (MA) der Fahrzeug-Hochvoltspannungsschutzschaltung über eine Induktivität (L) und/oder einen Widerstand verbunden ist.

5. Fahrzeug-Hochvoltspannungsschutzschaltung aufweisend
- mindestens einen Schutzanschluss (SA) eingerichtet zur Verbindung mit einer Niedervoltleitung (NL), die aus einem Hochvoltbereich (HV) herausgeführt ist,
- mindestens einen Varistor (V) oder mindestens einSpannungsbegrenzungselement, über den beziehungsweise das der Schutzanschluss (SA) mit einem Masseanschluss (MA) der Fahrzeug-Hochvoltspannungsschutzschaltung verbunden ist, wobei der Masseanschluss (MA) der Fahrzeug-Hochvoltspannungsschutzschaltung mit einem Massepotential (M) des Niedervoltbereichs (NV) verbunden ist und das Massepotential (M) galvanisch getrennt ist von dem Hochvoltbereich (HV), sowie
- eine Erfassungseinrichtung (EE; GE), die signalübertragend mit dem Varistor (V) beziehungsweise Spannungsbegrenzungselement verbunden ist und eingerichtet ist, den kapazitiven Anteil der Wechselstromimpedanz des Varistors (V) beziehungsweise des Spannungsbegrenzungselements zu erfassen, und
- eine Auswerteeinrichtung (K), wobei die Auswerteeinrichtung (K) eingerichtet ist, den von der Erfassungseinrichtung (EE; GE) erfassten kapazitiven Anteil mit einem Kapazitäts-Nennwert des Varistors (V) zu vergleichen und bei einer Abweichung, die einen vorgegebenen Betrag übersteigt, an einem Signalausgang der Auswerteeinrichtung (K) ein Fehlersignal auszugeben, das den Varistor (V) beziehungsweise das Spannungsbegrenzungselement als fehlerhaft kennzeichnet.

6. Fahrzeug-Hochvoltspannungsschutzschaltung nach Anspruch 5 mit
(a) einer Wechselstromquelle (Q), die mit dem mindestens einen Varistor (V) beziehungsweise Spannungsbegrenzungselement verbunden ist und eingerichtet ist, einen Wechselstrom in den Varistor (V) beziehungsweise in das Spannungsbegrenzungselement einzuprägen, wobei die Erfassungseinrichtung (ME; EE) mit dem Varistor (V) beziehungsweise dem Spannungsbegrenzungselement verbunden ist und eingerichtet ist, die Spannung zu erfassen, die sich durch den eingeprägten Wechselstrom am Varistor (V) beziehungsweise am Spannungsbegrenzungselement ergibt, oder
(b) einer Wechselspannungsquelle, die mit dem mindestens einen Varistor (V) beziehungsweise Spannungsbegrenzungselement verbunden ist und eingerichtet ist, eine Wechselspannung an dem Varistor (V) beziehungsweise Spannungsbegrenzungselement anzulegen, wobei die Erfassungseinrichtung (EE; GE) mit dem Varistor (V) beziehungsweise Spannungsbegrenzungselement verbunden ist und eingerichtet ist, den Strom zu erfassen, der sich durch die angelegte Wechselspannung am Varistor (V) beziehungsweise am Spannungsbegrenzungselement ergibt.

7. Fahrzeug-Hochvoltspannungsschutzschaltung nach Anspruch 5 oder 6 mit mehreren Varistoren beziehungsweise Spannungsbegrenzungselementen, wobei für jeden Varistor (V) beziehungsweise jedes Spannungsbegrenzungselement oder einer Untergruppe hiervon eine Erfassungseinrichtung (EE') vorgesehen ist, die signalübertragend mit dem jeweiligen Varistor (V) beziehungsweise Spannungsbegrenzungselement verbunden ist, oder ein Auswahlschalter (MX) vorgesehen ist, über den die Erfassungseinrichtung (EE') mit allen Varistoren (V) beziehungsweise Spannungsbegrenzungselementen oder einer Untergruppe hiervon verbunden ist und der Auswahlschalter (MX) eingerichtet ist, die Erfassungseinrichtung (EE') mit einem ausgewählten Varistor (V) beziehungsweise Spannungsbegrenzungselement oder mit einer ausgewählten Untergruppe der Varistoren (V) oder Spannungsbegrenzungselementen zu verbinden.

8. Fahrzeug-Hochvoltspannungsschutzschaltung nach Anspruch 5, 6 oder 7, wobei der mindestens eine Varistor (V) beziehungsweise das mindestens eine Spannungsbegrenzungselement über eine Induktivität (L) und/oder einen Widerstand mit dem Masseanschluss (MA) verbunden ist.

9. Hochvolt-Fahrzeugbordnetz mit einem räumlich begrenzten Hochvoltbereich (HV), aus dem mindestens eine Niedervoltleitung (NL) herausgeführt ist, wobei das Hochvolt-Fahrzeugbordnetz ein Fahrzeug-Hochvoltspannungs-Schutzschaltung nach einem der Ansprüche 5 - 8 umfasst, wobei der Schutzanschluss (SA) der Fahrzeug-Hochvoltspannungsschutzschaltung mit der mindestens einen Niedervoltleitung (NL) verbunden ist, der Hochvoltbereich (HV) mittels einer Isolation (IN) von einem Niedervoltbereich (NV) getrennt ist, in welchem sich die Fahrzeug-Hochvoltspannungsschutzschaltung befindet, und der Masseanschluss (MA) der Fahrzeug-Hochvoltspannungsschutzschaltung mit einem Massepotential (M) des Niedervoltbereichs (NV) verbunden ist, wobei das Massepotential (M) galvanisch getrennt ist von dem Hochvoltbereich (HV).

10. Hochvolt-Fahrzeugbordnetz nach Anspruch 9, wobei die mindestens eine Niedervoltleitung (NL) als Sensorleitung (SL), Datenleitung (DL) oder Niedervolt-Versorgungsleitung (VL) ausgebildet ist.

## Claims

1. Method for checking the functionality of a high-voltage protective device for an on-board vehicle electrical system, which high-voltage protective device has a varistor or a different voltage limiting element, having the steps of:
- detecting the capacitive component of the alternating current impedance of the varistor or the voltage limiting element;
- comparing the capacitive component to a rated capacitance value, wherein the rated capacitance value is characteristic of the capacitance of a functioning varistor or a functioning voltage limiting element;
- determining a defective state of the varistor or the voltage limiting element if the comparison determines that the capacitive component deviates from the rated capacitance value by more than a predetermined magnitude, wherein the method is carried out on the varistor (V) or voltage limiting element, via which the potential of a low-voltage line (NV), which is led out of a high-voltage zone (HV), is connected to an earth connector (MA) of the high-voltage protection circuit for a vehicle, and the high-voltage zone is isolated by way of an insulation from a low-voltage zone (NV) in which the high-voltage protection circuit for a vehicle is located, and the earth connector (MA) of the high-voltage protection circuit for a vehicle is connected to an earth potential (M) of the low-voltage zone (NV) and the earth potential (M) is galvanically isolated from the high-voltage zone (HV) .

2. Method according to Claim 1, wherein the detection is carried out
(a) by applying an alternating current signal to the varistor (V) or to the voltage limiting element and by detecting the associated AC voltage signal that is applied to the varistor (V) or to the voltage limiting element, or
(b) by applying an AC voltage signal to the varistor (V) or to the voltage limiting element and by detecting the associated alternating current signal that is applied to the varistor or to the voltage limiting element.

3. Method according to Claim 1 or 2, wherein, for a plurality of varistors (V) or voltage limiting elements, the respective capacitive component of the alternating current impedance is detected and wherein
- the capacitive components of the varistors (V) or the voltage limiting elements are detected using individual devices (EE) and, for each varistor (V) or for each voltage limiting element or a subgroup thereof, its own signal source (Q') applies an alternating current signal and/or, for each varistor (V) or voltage limiting element or a subgroup thereof, its own measuring device (ME') detects the resulting signal at the associated varistor (V) or at the voltage limiting element, or
- the capacitive components of the plurality of varistors (V) or voltage limiting elements are detected by signal multiplexing (SA') using the same device (EE') and the same signal source (Q) applies an alternating current signal to all varistors (V) or voltage limiting elements or to a subgroup thereof and/or the same measuring device (ME) detects the resulting signal at the varistors (V) or at the voltage limiting elements for all varistors (V) or voltage limiting elements or for a subgroup thereof.

4. Method according to any one of the preceding claims, wherein the varistor (V) or the voltage limiting element is connected to the earth connector (MA) of the high-voltage protection circuit for a vehicle via an inductor (L) and/or a resistor.

5. High-voltage protection circuit for a vehicle having
- at least one protective connector (SA) that is set up for connection to a low-voltage line (NL) which is led out of a high-voltage zone (HV),
- at least one varistor (V) or at least one voltage limiting element, via which the protective connector (SA) is connected to an earth connector (MA) of the high-voltage protection circuit for a vehicle, wherein the earth connector (MA) of the high-voltage protection circuit for a vehicle is connected to an earth potential (M) of the low-voltage zone (NV) and the earth potential (M) is galvanically isolated from the high-voltage zone (HV), and
- a detection device (EE; GE) which is connected to the varistor (V) or voltage limiting element in a signal-transmitting manner and is set up to detect the capacitive component of the alternating current impedance of the varistor (V) or the voltage limiting element, and
- an evaluating device (K), wherein the evaluating device (K) is set up to compare the capacitive component, which is detected by the detection device (EE; GE), to a rated capacitive value of the varistor (V) and to output a fault signal at a signal output of the evaluating device (K) in the event of a deviation which exceeds a predetermined magnitude, which fault signal identifies the varistor (V) or the voltage limiting element as defective.

6. High-voltage protection circuit for a vehicle according to Claim 5, having
(a) an alternating current source (Q) which is connected to the at least one varistor (V) or voltage limiting element and is set up to impress an alternating current into the varistor (V) or into the voltage limiting element, wherein the detection device (ME; EE) is connected to the varistor (V) or the voltage limiting element and is set up to detect the voltage that results due to the impressed alternating current at the varistor (V) or at the voltage limiting element, or
(b) an AC voltage source which is connected to the at least one varistor (V) or voltage limiting element and is set up to apply an AC voltage to the varistor (V) or voltage limiting element, wherein the detection device (EE; GE) is connected to the varistor (V) or voltage limiting element and is set up to detect the current that results due to the applied AC voltage at the varistor (V) or at the voltage limiting element.

7. High-voltage protection circuit for a vehicle according to Claim 5 or 6, having a plurality of varistors or voltage limiting elements, wherein one detection device (EE') is provided for each varistor (V) or each voltage limiting element or a subgroup thereof, which is connected to the respective varistor (V) or voltage limiting element in a signal-transmitting manner, or a selection switch (MX) is provided, by means of which the detection device (EE') is connected to all varistors (V) or voltage limiting elements or a subgroup thereof and the selection switch (MX) is set up to connect the detection device (EE') to a selected varistor (V) or voltage limiting element or to a selected subgroup of the varistors (V) or voltage limiting elements.

8. High-voltage protection circuit for a vehicle according to Claim 5, 6 or 7, wherein the at least one varistor (V) or the at least one voltage limiting element is connected via an inductance (L) and/or a resistor to the earth connector (MA).

9. High-voltage on-board vehicle electrical system having a spatially delimited high-voltage zone (HV), out of which at least one low-voltage line (NL) is led, wherein the high-voltage on-board vehicle electrical system comprises a high-voltage protection circuit for a vehicle according to one of Claims 5-8, wherein the protective connector (SA) of the high-voltage protection circuit for a vehicle is connected to the at least one low-voltage line (NL), the high-voltage zone (HV) is isolated by means of an insulation (IN) from a low-voltage zone (NV) in which the high-voltage protection circuit for a vehicle is located, and the earth connector (MA) of the high-voltage protection circuit for a vehicle is connected to an earth potential (M) of the low-voltage zone (NV), wherein the earth potential (M) is galvanically isolated from the high-voltage zone (HV).

10. High-voltage on-board vehicle electrical system according to Claim 9, wherein the at least one low-voltage line (NL) is designed as a sensor line (SL), data line (DL) or low-voltage supply line (VL).

## Revendications

1. Procédé de vérification de la fonctionnalité d'un dispositif de protection haute tension de réseau embarqué de véhicule, qui comporte une varistance ou un autre élément limiteur de tension, avec les étapes suivantes :
- détection de la composante capacitive de l'impédance en courant alternatif de la varistance ou de l'élément limiteur de tension ;
- comparaison de la composante capacitive à une valeur de capacité nominale, la valeur de capacité nominale caractérisant la capacité d'une varistance en état de fonctionnement ou d'un élément limiteur de tension en état de fonctionnement ;
- détermination d'un état défectueux de la varistance ou de l'élément limiteur de tension lorsque la comparaison révèle que la composante capacitive s'écarte de la valeur de capacité nominale de plus d'une valeur prédéfinie,
le procédé étant exécuté sur la varistance (V) ou l'élément limiteur de tension, par laquelle ou lequel le potentiel d'une ligne de basse tension (NV), qui sort d'une plage de haute tension (HV), est relié à une borne de masse (MA) du circuit de protection haute tension de véhicule, et la plage de haute tension étant séparée par une isolation d'une plage de basse tension (NV), dans laquelle se trouve le circuit de protection haute tension de véhicule, et la borne de masse (MA) du circuit de protection haute tension de véhicule étant reliée à un potentiel de masse (M) de la plage de basse tension (NV), et le potentiel de masse (M) étant séparé galvaniquement de la plage de haute tension (HV).

2. Procédé selon la revendication 1, la détection étant effectuée
(a) en appliquant un signal de courant alternatif sur la varistance (V) ou sur l'élément limiteur de tension et en détectant le signal de tension alternative associé appliqué sur la varistance (V) ou sur l'élément limiteur de tension ou
(b) en appliquant un signal de tension alternative sur la varistance (V) ou sur l'élément limiteur de tension et en détectant le signal de courant alternatif associé appliqué sur la varistance ou sur l'élément limiteur de tension.

3. Procédé selon la revendication 1 ou 2, la composante capacitive respective de l'impédance en courant alternatif étant détectée pour plusieurs varistances (V) ou éléments limiteurs de tension, et
- les composantes capacitives des varistances (V) ou des éléments limiteurs de tension étant détectées avec des systèmes individuels (EE) et une source de signaux dédiée (Q') appliquant un signal de courant alternatif pour chaque varistance (V) ou pour chaque élément limiteur de tension ou pour un sous-groupe de ceux-ci et/ou un système de mesure dédié (ME') détectant le signal résultant sur la varistance (V) associée ou sur l'élément limiteur de tension pour chaque varistance (V) ou élément limiteur de tension ou un sous-groupe de ceux-ci, ou
- les composantes capacitives des plusieurs varistances (V) ou éléments limiteurs de tension étant détectées par multiplexage de signaux (SA') avec le même système (EE') et la même source de signaux (Q) appliquant un signal de courant alternatif sur toutes les varistances (V) ou éléments limiteurs de tension ou sur un sous-groupe de ceux-ci et/ou le même système de mesure (ME) détectant le signal résultant sur les varistances (V) ou sur les éléments limiteurs de tension pour toutes les varistances (V) ou éléments limiteurs de tension ou pour un sous-groupe de ceux-ci.

4. Procédé selon l'une des revendications précédentes, la varistance (V) ou l'élément limiteur de tension étant relié(e) à la borne de masse (MA) du circuit de protection haute tension de véhicule par une inductance (L) et/ou une résistance.

5. Circuit de protection haute tension de véhicule comportant
- au moins un raccord de protection (SA) mis au point pour être relié à une ligne de basse tension (NL), qui sort d'une plage de haute tension (HV),
- au moins une varistance (V) ou au moins un élément limiteur de tension, par laquelle ou lequel la borne de protection (SA) est reliée à une borne de masse (MA) du circuit de protection haute tension de véhicule, la borne de masse (MA) du circuit de protection haute tension de véhicule étant reliée à un potentiel de masse (M) de la plage de basse tension (NV) et le potentiel de masse (M) étant séparé galvaniquement de la plage de haute tension (HV), et
- un système de détection (EE ; GE), qui est relié de manière à transmettre des signaux à la varistance (V) ou à l'élément limiteur de tension et qui est mis au point pour détecter la composante capacitive de l'impédance en courant alternatif de la varistance (V) ou de l'élément limiteur de tension, et
- un système d'évaluation (K), le système d'évaluation (K) étant mis au point pour comparer la composante capacitive détectée par le système de détection (EE ; GE) à une valeur de capacité nominale de la varistance (V) et, en cas d'écart dépassant une valeur prédéfinie, émettre à une sortie de signal du système d'évaluation (K) un signal d'erreur, qui caractérise la varistance (V) ou l'élément limiteur de tension comme étant défectueux.

6. Circuit de protection haute tension de véhicule selon la revendication 5 avec
(a) une source de courant alternatif (Q), qui est reliée à l'au moins une varistance (V) ou à l'au moins un élément limiteur de tension et qui est mise au point pour imprimer un courant alternatif dans la varistance (V) ou dans l'élément limiteur de tension, le système de détection (ME ; EE) étant relié à la varistance (V) ou à l'élément limiteur de tension et étant mis au point pour détecter la tension, qui résulte du courant alternatif imprimé sur la varistance (V) ou sur l'élément limiteur de tension, ou
(b) une source de tension alternative, qui est reliée à l'au moins une varistance (V) ou à l'au moins un élément limiteur de tension et qui est mise au point pour appliquer une tension alternative sur la varistance (V) ou l'élément limiteur de tension, le système de détection (EE ; GE) étant relié à la varistance (V) ou à l'élément limiteur de tension et étant mis au point pour détecter le courant, qui résulte de la tension alternative appliquée sur la varistance (V) ou sur l'élément limiteur de tension.

7. Circuit de protection haute tension de véhicule selon la revendication 5 ou 6 avec plusieurs varistances ou éléments limiteurs de tension, un système de détection (EE') étant prévu pour chaque varistance (V) ou chaque élément limiteur de tension ou un sous-groupe de ceux-ci, lequel est relié à la varistance (V) respective ou à l'élément limiteur de tension respectif de manière à transmettre des signaux, ou un commutateur de sélection (MX) étant prévu, par lequel le système de détection (EE') est relié à toutes les varistances (V) ou à tous les éléments limiteurs de tension ou à un sous-groupe de ceux-ci, et le commutateur de sélection (MX) étant mis au point pour relier le système de détection (EE') à une varistance (V) sélectionnée ou à un élément limiteur de tension sélectionné ou à un sous-groupe sélectionné des varistances (V) ou des éléments limiteurs de tension.

8. Circuit de protection haute tension de véhicule selon la revendication 5, 6 ou 7, l'au moins une varistance (V) ou l'au moins un élément limiteur de tension étant relié(e) à la borne de masse (MA) par une inductance (L) et/ou une résistance.

9. Réseau embarqué haute tension de véhicule avec une plage de haute tension (HV) limitée spatialement, duquel sort au moins une ligne de basse tension (NL), le réseau embarqué haute tension de véhicule comprenant un circuit de protection haute tension de véhicule selon l'une des revendications 5 à 8, la borne de protection (SA) du circuit de protection haute tension de véhicule étant reliée à l'au moins une ligne de basse tension (NL), la plage de haute tension (HV) étant séparée au moyen d'une isolation (IN) d'une plage de basse tension (NV), dans laquelle se trouve le circuit de protection haute tension de véhicule, et la borne de masse (MA) du circuit de protection haute tension de véhicule étant reliée à un potentiel de masse (M) de la plage de basse tension (NV), le potentiel de masse (M) étant séparé galvaniquement de la plage de haute tension (HV).

10. Réseau embarqué haute tension de véhicule selon la revendication 9, l'au moins une ligne de basse tension (NL) étant formée comme une ligne de capteur (SL), une ligne de données (DL) ou une ligne d'alimentation de basse tension (VL).
